# DEMANDE DE BREVET EUROPEEN

(11) **EP 1 531 409 A2**
(43) Date de publication de la demande: **18.05.2005**
(21) Numéro de dépôt: 04105742.3
(22) Date de dépôt: 12.11.2004
(51) Int. Cl.: G06F 17/50

(54) **Procédé de vérification d'un circuit intégré**

(30) Priorité: 13.11.2003 FR 0350833
(71) Demandeur: DOLPHIN INTEGRATION, F-38240 Meylan (FR)
(72) Inventeur: Decloedt, Loic, 38000, GRENOBLE (FR)
(74) Mandataire: de Beaumont, Michel

(57) **Abrégé**

L'invention concerne un procédé de vérification d'un circuit intégré comprenant des composants reliés par des connexions, le circuit intégré étant défini par des représentations "physique" et "schématique", comprenant les étapes suivantes : établir une description physique annotée du circuit permettant d'associer à chaque connexion de la représentation schématique plusieurs polygones de la représentation physique constituant une piste ; définir au moins un type de signal pouvant se propager sur les connexions ; définir, pour chaque type de signal, des règles devant être vérifiées par chaque piste sur laquelle le type de signal considéré peut se propager, des caractéristiques géométriques propres d'une piste donnée et/ou des caractéristiques relatives au positionnement d'une piste donnée par rapport à d'autres pistes devant être vérifiées pour chaque règle ; déterminer, pour chaque connexion, si les pistes associées aux connexions étudiées vérifient les règles correspondant aux types de signaux susceptibles de se propager sur chaque connexion.

## Description

La présente invention concerne les procédés de vérification d'un circuit intégré préalablement à sa fabrication.

La fabrication d'un circuit intégré est effectuée à partir d'un jeu de masques. Chaque masque comprend de façon générale un ensemble de polygones qui permettent de définir des zones semiconductrices, des zones d'isolement, des grilles de transistors, des pistes conductrices et d'autres éléments du circuit intégré. Le jeu de masques correspondant à un circuit intégré est réalisé à partir d'une représentation "physique" du circuit sur laquelle sont définis un ensemble de polygones de divers types à partir desquels il est possible de fabriquer l'ensemble des masques.

Les polygones définis sur une représentation physique d'un circuit intégré correspondent à un ensemble de composants reliés entre eux et à des plots d'entrée/sortie par des connexions électriques. Les composants et les connexions sont de façon générale définis explicitement dans une représentation schématique du circuit intégré. Chaque composant et chaque connexion de la représentation schématique correspond à un ensemble de polygones définis sur la représentation physique. Chaque ensemble de polygones associé à une connexion sera par la suite appelé une piste.

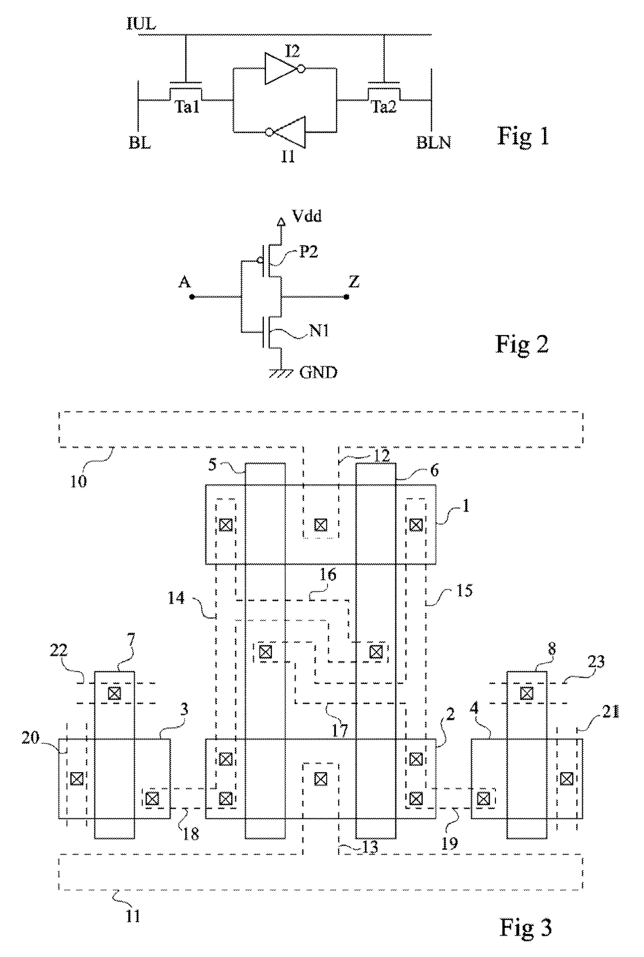

La figure 1 est un exemple de représentation schématique d'un circuit intégré, et plus particulièrement d'un point mémoire SRAM correspondant à un élément de base d'une mémoire SRAM. Le point mémoire SRAM comprend deux inverseurs I1 et I2 en boucle, la sortie d'un inverseur étant reliée à l'entrée de l'autre. Le point mémoire SRAM comprend en outre deux transistors d'accès NMOS Ta1 et Ta2 commandés par une ligne de mot WL. Le transistor Ta1 est placé entre la sortie de l'inverseur I1 et une ligne de bit BL. Le transistor Ta2 est placé entre la sortie de l'inverseur I2 et une ligne de bit BLN.

La figure 2 est une représentation schématique d'un inverseur tel que les inverseurs I1 et I2. Un inverseur comprend un transistor PMOS P1 et un transistor NMOS N1 en série entre une alimentation Vdd et une masse GND. Les grilles des transistors P1 et N1 sont reliées à un plot d'entrée A. Les drains des transistors P1 et N1 sont reliés à un plot de sortie Z.

La figure 3 est un exemple de représentation physique d'un point mémoire SRAM correspondant à la représentation électrique décrite ci-dessus. Cette représentation physique correspond sensiblement à une vue de dessus des masques du circuit intégré telle qu'elle pourrait être vue sur un écran d'ordinateur et donc ce qui est en haut de la figure est au-dessus de ce qui est en bas de la figure. De même, ce qui décrit comme étant horizontal ou vertical se réfère à une représentation sur un écran. Ces considérations seront valables pour l'ensemble des représentations physiques décrites ci-après. Chaque transistor est représenté par une zone active et une zone de grille se coupant perpendiculairement. Des zones métalliques permettent de relier entre elles des zones actives et/ou des zones de grille.

Deux zones actives 1 et 2 de forme rectangulaire sont placées horizontalement, la zone 1 étant en haut et la zone 2 en bas de la figure 3. Deux zones actives 3 et 4 de forme rectangulaire sont placées horizontalement de chaque côté de la zone active 2. Deux zones de grille 5 et 6 sensiblement en forme de pistes verticales coupent les zones actives 1 et 2 perpendiculairement, les zones 5 et 6 étant respectivement placées à gauche et à droite. Deux zones de grilles 7 et 8 sensiblement en forme de courtes pistes verticales coupent les zones actives 3 et 4. La zone active 1 est dopée de type P et les zones actives 2, 3 et 4 sont dopées de type N.

La portion de la zone active 1 située entre les zones de grille 5 et 6 constitue la source des transistors PMOS de chacun des inverseurs I1 et I2. Les portions de la zone active 1 situées de part et d'autres des zones de grille 5 et 6 constituent les drains des transistors PMOS des inverseurs I1 et I2. De même, la portion de la zone active 2 située entre les zones de grille 5 et 6 constitue la source des transistors NMOS de chacun des inverseurs I1 et I2. Les portions de la zone active 2 situées de part et d'autres des zones de grille 5 et 6 constituent les drains des transistors NMOS des inverseurs I1 et I2. Les portions des zones actives 3 et 4 situées de part et d'autre des zones de grilles 7 et 8 constituent les zones de source/drain des transistors d'accès Ta1 et Ta2.

Deux zones métalliques horizontales 10 et 11 en forme de rails sont placées respectivement au-dessus et en dessous des zones actives 1, 2, 3 et des zones de grille 5, 6, 7 et 8. Les zones 10 et 11 sont destinées à être reliées respectivement à l'alimentation Vdd et à la masse GND. Une zone métallique 12 relie la piste 10 (Vdd) à la portion de la zone active 1 constituant la source des transistors PMOS. Une zone métallique 13 relie la piste 11 (GND) à la portion de la zone active 2 constituant la source des transistors NMOS. Une zone métallique 14 relie les portions gauches des zones actives 1 et 2 correspondant à des zones de drain. De même, une zone métallique 15 relie les portions droites des zones actives 1 et 2 correspondant à des zones de drain. Deux zones métalliques 16 et 17 relient les zones métalliques 14 et 15 respectivement aux zones de grille 6 et 5. Une zone métallique 18 relie les portions des zones actives 2 et 3 de source/drain situées l'une à côté de l'autre. De même, une zone métallique 19 relie les portions des zones actives 2 et 4 de source/drain situées l'une à côté de l'autre. Les portions latérales des zones actives 3 et 4 sont reliées respectivement à deux zones métalliques 20 et 21 correspondant aux lignes de bit BL et BLN. Les zones de grille 7 et 8 sont reliées respectivement à deux zones métalliques 22 et 23 correspondant aux lignes de mots WL et WLN. Chaque liaison entre une zone métallique et une zone active ou une zone de grille est assurée par un via conducteur représenté par une croix placée dans un carré.

Les procédés existants de vérification d'un circuit intégré défini par une représentation physique et une représentation schématique telles que décrites précédemment, comprennent généralement les trois étapes suivantes.

Une première étape consiste à vérifier la fonctionnalité du circuit, ceci étant de façon générale réalisé au moyen d'une simulation électrique effectuée à partir de la représentation schématique du circuit. Lors d'une simulation électrique, on définit à partir d'un état électrique initial du circuit une suite d'états correspondant à une suite de stimuli appliqués sur les entrées du circuit. Pour chaque état du circuit, on définit le potentiel électrique, ou le niveau logique "0" ou "1", de chacune des connexions du circuit. Si nécessaire, notamment dans le cas des circuits dits "analogiques", on détermine aussi la valeur des courants entrants ou sortants de chacun des composants du circuit. L'analyse de la suite d'états du circuit obtenue après simulation permet de vérifier la fonctionnalité du circuit.

Une deuxième étape consiste à vérifier que le circuit tel que défini par la représentation physique satisfait à toutes les contraintes de fabrication. Cette deuxième étape regroupe plusieurs vérifications connues sous les noms de DRC, DFM et ERC (de l'anglais Design Rule Check, Design For Manufacturing et Electrical Rule Check) et consiste principalement à vérifier les caractéristiques géométriques de chaque polygone (largeur, surface...) et les espacements entre les divers polygones de la représentation physique du circuit.

Une troisième étape, connue sous le nom de LVS (de l'anglais, Layout versus schematic), consiste à vérifier que l'ensemble des polygones de la représentation physique correspondent bien aux composants et connexions de la représentation schématique. Pour ce faire, on "extrait" de la représentation physique une première liste de composants et de connexions en procédant à une reconnaissance de groupes de polygones correspondant chacun soit à un type de composant connu soit à une connexion. A titre d'exemple, l'association d'une zone active et d'une zone de grille se coupant perpendiculairement est reconnue comme définissant un transistor. En parallèle, on établit une seconde liste de composants et de connexions à partir de la représentation schématique. On vérifie ensuite que les deux listes comportent les mêmes composants et des connexions identiques entre les divers composants.

Ces procédés existants de vérification d'un circuit intégré ne permettent pas de détecter certaines faiblesses d'un circuit fabriqué selon les procédés les plus récents. Les faiblesses possibles d'un circuit "moderne" sont de diverses natures et chaque type de faiblesse engendre un disfonctionnement du circuit dans des conditions d'utilisation particulières du circuit. Lorsque le circuit est utilisé dans des conditions susceptibles de "révéler" certaines faiblesses du circuit, les phénomènes les plus courants pouvant se produire au niveau du circuit sont les suivants.

Un phénomène connu est l'électromigration d'une ou de plusieurs zones métalliques qui conduit généralement à une coupure des pistes métalliques. Les risques potentiels d'électromigration de pistes sont d'autant plus importants que la taille et la complexité des circuits est grande. Aucune méthode de vérification du circuit ne permet de détecter des zones à risques. Seule la vigilance du concepteur peut éviter ce type de problème.

Un autre phénomène connu est la modification du potentiel, ou autrement dit un changement d'état, d'une piste métallique suite à un couplage capacitif parasite entre deux pistes métalliques.

Un autre phénomène connu est la diminution locale de la tension d'alimentation, dans des parties d'un circuit où de nombreux composants conduisent simultanément de forts courants électriques, la diminution de tension étant proportionnelle au courant total demandé et à la résistance des pistes d'alimentation. Ce phénomène est généralement observé dans des circuits dits synchrones pour lesquels les registres de bascules commutent tous au même moment. Une diminution locale de l'alimentation entraîne un mauvais fonctionnement des cellules sous-alimentées.

Certaines zones de faiblesses pouvant conduire à l'apparition des deux derniers phénomènes susmentionnés peuvent être partiellement détectés en effectuant une simulation électrique du circuit à partir d'une représentation schématique "perfectionnée" incluant des composants parasites (résistances, condensateurs, bobines) déterminés à partir de la représentation physique du circuit et notamment à partir de l'ensemble des zones conductrices correspondant aux diverses connexions définies dans la représentation schématique. Cependant, les procédés actuels d'extraction de l'ensemble de ces composants parasites ne permettent pas de déterminer suffisamment précisément les valeurs résistives, capacitives ou inductives des composants parasites, et cela d'autant plus que la taille du circuit est importante et que la représentation physique est organisée en plusieurs niveaux hiérarchiques. De plus, la taille de la représentation schématique "perfectionnée" obtenue après extraction des composants parasites est généralement deux à trois fois plus élevée que la représentation schématique de base et sa simulation électrique peut être très longue et demander de nombreuses ressources informatiques. La difficulté de simulation conduit alors à limiter le nombre de stimuli testés, ce qui diminue fortement les possibilités de détection de faiblesses éventuelles. En outre, même si de larges ressources matérielles et temporelles sont disponibles, la définition de stimuli "exhaustifs" permettant de tester tous les cas d'utilisation s'avère souvent impossible.

Les problèmes susmentionnés apparaissent quand une piste métallique a une forme ou un positionnement par rapport aux autres pistes qui est inapproprié à son utilisation. Un problème peut se produire sur une piste par exemple dans le cas où la densité de courant la parcourant est trop importante ou dans le cas où la fréquence du signal électrique la traversant ou traversant une piste proche est trop élevée.

Un objet de la présente invention est de prévoir un procédé de vérification d'un circuit intégré qui soit capable de vérifier rapidement que chaque piste métallique a des caractéristiques géométriques et/ou un positionnement par rapport aux autres pistes qui est adapté à son utilisation.

Pour atteindre cet objet, la présente invention prévoit un procédé de vérification d'un circuit intégré comprenant des composants reliés par des connexions, le circuit intégré étant défini par une représentation "physique" et une représentation "schématique", la représentation physique consistant en un assemblage de polygones de divers types utilisés pour réaliser un jeu de masques servant à la fabrication du circuit intégré, la représentation schématique définissant symboliquement les composants du circuit et les connexions entre ces composants, le procédé comprenant les étapes suivantes : établir une description physique annotée du circuit qui permette d'associer à chaque connexion de la représentation schématique un ensemble de polygones de la représentation physique constituant une piste ; définir au moins un type de signal électrique susceptible de se propager sur les diverses connexions du circuit ; définir, pour chaque type de signal, une ou plusieurs règles devant être vérifiées par chacune des pistes correspondant aux connexions sur lesquelles le type de signal considéré est susceptible de se propager, des caractéristiques géométriques propres d'une piste donnée et/ou des caractéristiques relatives au positionnement d'une piste donnée par rapport à d'autres pistes devant être vérifiées pour chaque règle ; déterminer, pour tout ou partie des connexions, si les pistes associées aux connexions étudiées vérifient la ou les règles correspondant aux types de signaux susceptibles de se propager sur chacune de ces connexions.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une représentation schématique, précédemment décrite, d'un point mémoire SRAM ;
la figure 2 est une représentation schématique, précédemment décrite, d'un inverseur ;
la figure 3 est une représentation physique, précédemment décrite, du point mémoire SRAM de la figure 1 ;
la figure 4 est une représentation physique d'un inverseur ;
la figure 5 est une représentation physique d'un transistor NMOS ;
la figure 6 est une représentation schématique d'un transistor MOS ;
la figure 7 est une représentation physique hiérarchique d'un point mémoire SRAM ;
la figure 8 est une vue en perspective d'une piste ;
la figure 9 est une vue en perspective d'une piste ;
la figure 10 est une vue en perspective d'une piste ;
la figure 11 est un schéma électrique équivalent de la piste représentée en figure 10 ; et
la figure 12 est une vue de dessus de deux pistes.

Le procédé de la présente invention permet, à partir d'une représentation physique et d'une représentation schématique d'un circuit intégré, de vérifier les caractéristiques géométriques propres d'une piste et/ou les caractéristiques de positionnement d'une piste par rapport aux positionnements d'autres pistes en fonction du type de signal électrique susceptible de se propager sur la piste étudiée. Pour effectuer une telle vérification, le procédé de la présente invention comprend plusieurs étapes définies ci-après.

### 1. Description physique annotée

Une première étape consiste à établir une description physique annotée du circuit à partir de laquelle il soit possible d'associer à chaque connexion de la représentation schématique du circuit une piste constituée d'un ou de plusieurs polygones de la représentation physique. La définition d'une description physique annotée d'un circuit est précisée ci-après à partir d'un exemple de circuit très simple, un inverseur, puis à partir d'un exemple de circuit "hiérarchique" plus compliqué.

### 1.1. Description physique annotée d'un circuit simple

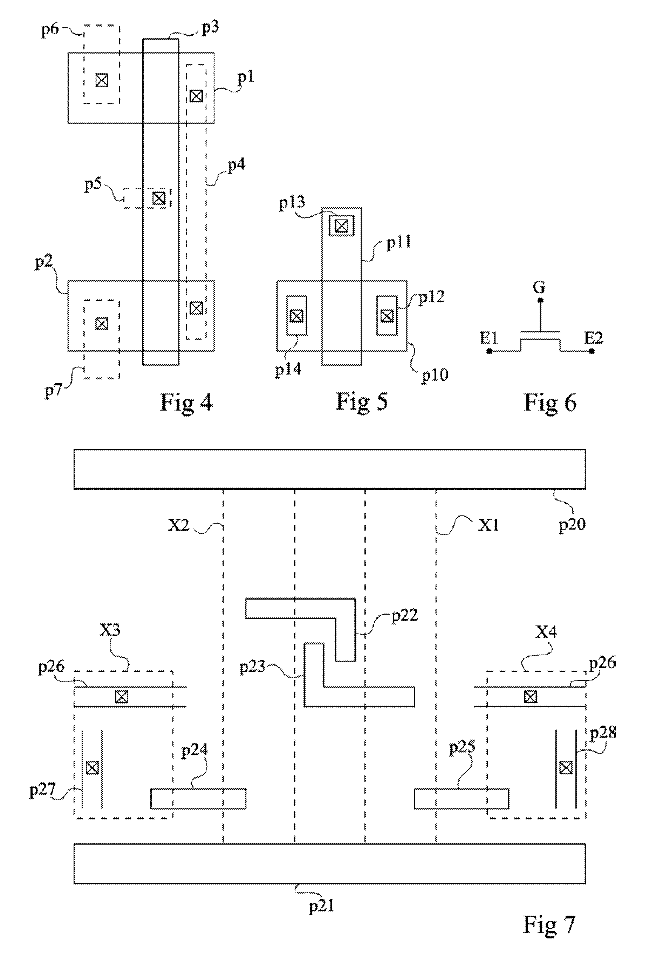

La figure 4 est une représentation physique d'un inverseur correspondant à la représentation schématique de la figure 2. Deux zones actives p1 et p2 de forme rectangulaire sont placées horizontalement l'une au-dessus de l'autre, la zone p1 étant au-dessus. Une zone de grille p3 sensiblement en forme de piste verticale coupe les zones actives p1 et p2 perpendiculairement. Les parties des zones actives p1 et p2 non recouvertes par la zone de grille p3 sont respectivement dopées de type P et N. Une zone métallique p4 verticale relie les portions des zones actives p1 et p2 situées à droite de la zone de grille p3. Une courte zone métallique p5 horizontale est reliée sensiblement au milieu de la zone de grille p3. La zone métallique p5 constitue la borne d'entrée de l'inverseur, la zone métallique p4 constituant la borne de sortie. Deux courtes zones métalliques p6 et p7 verticales sont reliées respectivement aux portions des zones actives p1 et p2 situées à gauche de la zone de grille p3. Les zones métalliques p6 et p7 sont destinées à être reliées respectivement à l'alimentation Vdd et à la masse GND. Les diverses zones métalliques sont reliées aux zones active ou de grille par un via conducteur représenté par une croix dans un carré. De plus, les zones métalliques sont dans cette représentation physique toutes réalisées sur le même niveau de métallisation du circuit intégré et plus précisément sur le premier niveau de métal "métal1" placé immédiatement au-dessus des composants actifs réalisés dans le substrat semiconducteur du circuit intégré.

La représentation physique d'un circuit intégré est de façon générale obtenue à l'aide d'un dispositif informatique. Les représentations physiques affichées sur l'écran du dispositif informatique sont sensiblement celles représentées en figures 3 et 4. Les polygones de la représentation physique sont décrits dans un ou plusieurs fichiers informatiques. Le ou les fichiers décrivant chacun des polygones constituent une description physique du circuit.

Dans une description physique classique d'un circuit, chaque polygone est défini par une suite de coordonnées des points définissant le polygone et un "type" indiquant si le polygone est une zone active, une zone de grille, une zone métallique ou autre. Dans l'exemple de l'inverseur représenté en figure 4 une description physique classique est donnée dans le tableau I suivant. Les coordonnées des points définissant les polygones sont données, dans cet exemple, dans un repère cartésien.
p1: (0;8) (4;8) (4;10) (0;10)-active
p2: (0;1) (4;1) (4;3) (0;3)-active
p3: (2;0,5) (3;0,5) (3;10,5) (2;10,5)-grille
p4: (3,25;1,25) (3,75;1,25) (3,75;9,75) (3,25;9,75)-métal1
p5: (1,5;5,25) (2,75;5,25) (2,75;5,75) (1,5;5,75)-métal1
p6: (0, 5; 8, 5) (1, 5; 8, 5) (1, 5; 11) (0,5;11)-métal1
p7: (0, 5; 0) (1, 5; 0) (1, 5; 2, 5) (0,5;2,5)-métal1

La première étape du procédé de l'invention vise à établir une description physique "annotée" du circuit qui contienne des éléments supplémentaires par rapport à une description courante telle que définie ci-dessus. Les éléments supplémentaires ont pour but d'indiquer si un polygone donné correspond à une des connexions définies dans la représentation schématique du circuit.

Dans l'exemple de l'inverseur, la description donnée ci-dessus est annotée selon le tableau II suivant :
p1: (0;8) (4;8) (4;10) (0;10)-active
p2: (0; 1) (4;1) (4; 3) (0;3)-active
p3: (2; 0, 5) (3; 0, 5) (3;10,5) (2;10,5)-grille
p4: (3, 25;1, 25) (3,75;1,25) (3, 75; 9, 75) (3,25;9,75)-métal1-**Z**
p5: (1,5;5,25)(2,75 5,25;)(2,75;5,75)(1,5;5,75)-métal1-**A**
p6: (0,5;8,5) (1,5;8,5) (1,5;11) (0,5;11)-métal1-**Vdd**
p7: (0,5;0) (1,5;0) (1,5;2,5) (0,5;2,5)-métal1-**GND**

A partir de cette description physique annotée, il est possible d'associer à chaque connexion de la représentation schématique de l'inverseur une piste de la représentation physique. Dans l'exemple ci-dessus chaque piste correspond à un seul polygone, ou autrement dit à une seule zone métallique. Cependant dans des circuits plus complexes, une piste est généralement constituée de plusieurs polygones.

Une description physique annotée d'un circuit peut être obtenue selon divers procédés.

Un procédé consiste à définir dès la création d'un polygone la connexion à laquelle il correspond. Ce procédé est en pratique envisageable uniquement pour des circuits très simples tels que l'inverseur décrit ci-dessus.

Un autre procédé consiste à créer initialement une représentation physique et une description physique associée classique qui ne contienne pas d'informations de connexions ou qui n'en contiennent que pour une partie des polygones. On extrait ensuite une première liste de composants et de connexions entre ces composants à partir de la représentation physique du circuit. Les composants et les connexions définis dans cette première liste ont des noms arbitraires. On définit, dans un fichier d'association, à quel ensemble de polygones correspond chaque composant et chaque connexion de la première liste, le ou les polygones correspondant à une connexion constituant une piste. En parallèle, on établit une seconde liste de composants et de connexions à partir de la représentation schématique. On détermine ensuite les correspondances entre les composants et les connexions des deux listes selon des méthodes connues et utilisées notamment dans les procédés de vérification connus sous le nom de LVS. A l'aide du fichier d'association, on détermine ensuite à quelle connexion de la représentation schématique correspond chaque piste et par extension chacun des polygones de la piste.

Ce procédé permet de réaliser une description annotée de façon automatique. Par rapport au premier procédé cité, il permet de gagner du temps lors de la conception de la représentation physique du circuit. Ce deuxième procédé peut notamment être utilisé lorsque le circuit a une taille importante.

### 1.2 Description physique annotée d'un circuit hiérarchique

Un exemple de circuit hiérarchique est donné ci-après. La représentation physique d'un circuit hiérarchique est construite à partir de "briques" de base. Chaque brique de base est une représentation physique d'un élément généralement repris plusieurs fois dans la représentation physique complète.

Les figures 5 et 6 sont respectivement une représentation physique d'un transistor NMOS et une représentation schématique de ce transistor. La représentation physique comprend une zone active p10 rectangulaire et horizontale, une zone de grille p11 rectangulaire et verticale coupant la zone active p10 perpendiculairement, ainsi que trois zones métalliques p12, p13 et p14 reliées respectivement à la portion de la zone active p10 située à droite de la zone de grille p11, à la portion de grille p11 et à la portion de la zone active p10 située à gauche de la zone de grille p11. Les zones métalliques p12, p13 et p14 sont toutes réalisées sur le premier niveau de métal "métal1" disponible. La représentation schématique comprend un transistor T dont la grille est reliée à une connexion, ou borne, G, et les zones de source/drain sont reliés à des connexions E1 et E2.

La figure 7 est une représentation physique hiérarchique d'un point mémoire SRAM construite à partir de deux briques de base : l'inverseur et le transistor NMOS représentés respectivement en figures 4 et 5. Le point mémoire comprend deux répliques X1 et X2 de l'inverseur et deux répliques X3 et X4 du transistor NMOS. Comme cela est connu de l'homme de l'art, d'un point de vue informatique, chaque réplique est généralement une copie virtuelle de la représentation physique d'une brique de base. En pratique, la représentation physique de l'inverseur est décrite une seule fois dans un fichier informatique et la représentation physique de chaque réplique est obtenue par lecture de la description de l'objet "copié". Les répliques X1, X3 et X4 sont placées sur la représentation physique du point mémoire SRAM avec une orientation identique à l'orientation de la brique de base correspondante. La réplique X2 de l'inverseur est par contre placée sur la représentation physique du point mémoire SRAM après avoir subi une transformation correspondant à la création du symétrique de la représentation physique de l'inverseur par rapport à une droite verticale se superposant avec les côtés verticaux gauches des zones actives p1 et p2. Les répliques X1 et X2 apparaissent comme partiellement superposées de façon que les pistes p6 (ou p7) de chaque réplique soient parfaitement superposées. La superposition de deux pistes de même type ne forme au final qu'une seule piste. Quant aux répliques X3 et X4, elles sont placées respectivement à gauche de la réplique X2 et à droite de la réplique X3.

Le point mémoire comprend en outre des zones métalliques positionnées de telles façon qu'une "mise à plat" de l'ensemble de la représentation physique hiérarchique de ce point mémoire redonnerait la représentation physique de la figure 3. Deux zones métalliques horizontales p20 et p21 sont placées respectivement au-dessus et en dessous des répliques X1 à X4, comme les zones 10 et 11 de la représentation physique "à plat" de la figure 3. Deux zones métalliques p22 et p23, ayant des formes respectivement identiques aux zones 16 et 17, sont placées de façon à relier la piste p4 d'un inverseur à la zone p5 de l'autre inverseur. Deux zones métalliques horizontales p24 et p25 sont placées de façon à relier respectivement la zone p4 de l'inverseur X2 à la zone p12 du transistor X3 et la zone p4 de l'inverseur X1 à la zone p14 du transistor X4. Les zones métalliques p22 à p25 sont réalisées sur un premier niveau de métal "métal1". Une zone métallique horizontale p26, représentée partiellement, est placée sur un deuxième niveau de métal "métal2" au-dessus des zones p13 des transistors X3 et X4 auxquelles elle est reliée par deux vias conducteurs représentés par une croix dans un carré. De même, deux zones métalliques verticales p27 et p28, représentées partiellement, sont placées sur un troisième niveau de métal "métal3" au-dessus respectivement de la piste p14 du transistor X3 et de la piste p10 du transistor X4. Les zones p27 et p28 sont reliées respectivement aux zones p14 de X3 et p10 de X4 par deux vias conducteurs superposés représentés par une croix dans un carré.

De façon générale, la description physique d'un circuit hiérarchique répertorie dans un fichier ou dans une partie d'un fichier, les différentes répliques positionnées et l'ensemble des zones et pistes ajoutées aux répliques. La description physique des éléments *répliqués* est généralement effectuée une seule fois dans des fichiers séparés ou dans des parties différentes d'un même fichier contenant éventuellement la description physique du circuit dans lequel sont placées les répliques. La description physique d'un élément répliqué répertorie des zones et éventuellement une réplique d'un autre élément dans le cas où il y a plus de deux niveaux hiérarchiques.

Dans l'exemple du point mémoire SRAM décrit ci-dessus, 3 fichiers ou parties de fichiers sont utilisés pour décrire l'inverseur, le transistor et le point mémoire représentés respectivement en figures 4, 5 et 7. La description physique annotée de l'inverseur est identique à celle donnée précédemment dans le tableau I.

La description physique annotée du transistor correspondant aux représentations physique et schématique des figures 5 et 6 est donnée dans le tableau III suivant :
p10: (0; 0, 5) (3; 0, 5) (3;2,5) (0;2,5)-active
p11: (1;0) (2;0) (2;4,5) (1;4,5)-grille
p12:(2,25;1)(2,75;1)(3;2)(2,25;2)-métal1-**E2**
p13: (1,25;3,5) (1,75;3,5) (1,75;4) (1,25;4)-métal1-**G**
p14: (0,25;1)(0,75;1)(0,75;2)(0,25;2)-métal1-**E1**

Une description physique classique du point mémoire SRAM correspondant aux représentations physique et schématique des figures 1 et 6 est donnée dans le tableau IV suivant :
X1: réplique inverseur-(6;1)
X2: réplique inverseur-symétrie verticale-(4;1)
X3: réplique transistor-(0;1,5)
X4: réplique transistor-(11;1,5)
p22: (4, 75; 7, 5) (7, 25; 7, 5) (7, 25; 6, 25) (7, 75; 6, 25) (7,75;8) (4,75;8)-métal1
p23: (6, 25; 5) (9, 25; 5) (9, 25; 5, 5) (6, 75; 5, 5) (6,75;6,75) (6,25;6,75)-métal1
p24: (2,25;1,75) (4,75;1,75) (4,75;2,25) (2,25;2,25)-métal1
p25: (9,25;1,75) (11,75;1,75) (11,75;2,25) (9,25;2,25)-métal1
p26: (0;5) (14;5) (14;5,5) (0;5,5)-métal2
p27: (0,25;0) (0,75;0) (0,75;13) (0,25;13)-métal3
p28: (13,25;0) (13,75;0) (13,75;13) (13,25;13)-métal3

Une description physique annotée du point mémoire SRAM est donnée dans le tableau V suivant :
p22: (4, 75; 7, 5) (7, 25; 7, 5) (7, 25; 6, 25) (7, 75; 6, 25) (7,75;8)(4,75;8)-métal1-**C2**
p23: (6,25;5) (9,25;5) (9,25;5,5) (6,75;5,5) (6,75;6,75)(6,25;6,75)-métal1-**C1**
p24: (2,25;1,75) (4,75;1,75) (4,75;2,25) (2,25;2,25)-métal1-**C1**
p25: (9, 25;1, 75) (11, 75;1, 75) (11, 75; 2, 25) (9,25;2,25)-métal1-**C2**
p26: (0; 5) (14; 5) (14; 5, 5) (0; 5, 5)-métal2-**WL**
p27: (0, 25; 0) (0, 75; 0) (0,75;13) (0, 25; 13)-métal3-**BLN**
p28: (13, 25; 0) (13, 75; 0) (13, 75; 13) (13, 25; 13)-métal3-**BL**
X1: réplique inverseur-(6;1)-**C2:Z,C1:A,Vdd:Vdd,GND:GND**
X2: réplique inverseur-symétrie verticale-(4;1)-**C1:Z,C2:A,Vdd:Vdd,GND:GND**
X3: réplique transistor-(0;1,5)-**C2:E2,BLN:E1,WL:G**
X4: réplique transistor-(11;1,5)-**C1:E1,BLN:E2,WL:G**

Dans la ligne relative à la réplique X1, **C2:Z** signifie que la zone associée à la connexion Z dans l'inverseur prolonge les zones associées à la connexion C2 dans le point mémoire. De même, **C1:A** signifie que la zone associée à la connexion A dans l'inverseur prolonge les zones associées à la connexion C1 dans le point mémoire. Les notations **Vdd:Vdd, et GND:GND** signifient que la zone associée à la connexion Vdd ou GND dans l'inverseur prolongent la zone associée à la connexion Vdd ou GND dans le point mémoire. Les notations utilisées pour les autres répliques sont identiques.

A partir des informations de connexions données dans chacune des descriptions physiques annotées, il est possible de retrouver à quelle connexion correspond chacune des zones métalliques définies sur les divers niveaux hiérarchiques, chaque ensemble de zones associé à une connexion constituant une piste.

Une description physique annotée d'un circuit dont la représentation physique est hiérarchique peut être obtenue selon divers procédés sensiblement identiques à ceux susmentionnés dans la partie précédente.

### 2. Types de signaux et règles associées - vérifications

Après avoir créée une description annotée du circuit étudié qui permette d'associer à chaque connexion de la représentation schématique du circuit une piste de la représentation physique du circuit, les étapes suivantes du procédé de la présente invention vise à vérifier que chaque piste est adaptée à son utilisation.

Chaque piste est utilisée pour propager un ou plusieurs types de signaux électriques qui pourront être déterminés par le concepteur du circuit. Chaque type de signal peut être décrit par une représentation temporelle du potentiel électrique d'une connexion et/ou du courant traversant une connexion. Les types de signaux les plus courants sont les suivants :
- un signal de type "stable", pour lequel la tension est sensiblement constante en fonction du temps.
- un signal de type "horloge", pour lequel la tension varie périodiquement du niveau bas "0" au niveau haut "1", chaque changement de niveau étant effectué rapidement, ou autrement dit avec un front raide.
- un signal de type "HF", pour lequel la tension varie rapidement en fonction du temps.
- un signal de type "aléatoire", pour lequel la tension change en fonction de l'activité du circuit.
- un signal de type "pic de courant", pour lequel à certains instants le courant atteint une valeur très élevée.
- un signal de type "fort courant", pour lequel un courant sensiblement élevé est observé pendant une durée relativement importante.

Les types de signaux donnés ci-dessus sont donnés à titre indicatif. Bien d'autres types de signaux pourront être imaginés par l'homme de l'art.

De plus, une piste donnée peut être utilisée pour propager des signaux de divers types. Une piste conduisant la tension d'alimentation propage un signal de type "stable", mais peut aussi propager un signal de type "pic de courant", ou "fort courant" en fonction notamment de l'activité du circuit.

En outre, les types de signaux susceptibles de se propager sur les diverses connexions du circuit peuvent être déterminés lors de la vérification fonctionnelle du circuit effectuée à l'aide d'une simulation électrique.

Les types de signaux étudiés au final seront en fait définis en fonction des problèmes que le concepteur du circuit souhaite détecter. Pour les problèmes d'électromigration on s'intéressera notamment aux signaux de type "pic de courant" ou "fort courant". Pour les problèmes de chute de tension on s'intéressera plutôt au signaux de type "stable", pour vérifier notamment le réseau d'alimentation du circuit. Pour les problèmes de couplages capacitifs parasites on s'intéressera aux signaux de type "horloge" ou "HF".

Une fois déterminés le ou les types de signaux que l'on souhaite étudier, on fixe pour chaque type de signal quelles sont les règles qui doivent être vérifiées par les pistes du circuit correspondant aux connexions sur lesquelles le type de signal considéré est susceptible de se propager. Des exemples de règles sont donnés ci-après dans le cas où l'on souhaite détecter des problèmes potentiels d'électromigration, de chute de tension ou de couplages capacitifs parasites.

Dans le cas du problème d'électromigration, on cherche à déterminer si les pistes correspondant à des connexions sur lesquelles sont susceptibles de se propager des signaux de type "pic de courant" ou "fort courant" sont suffisamment "larges". En d'autres termes, on cherche à déterminer si en tout point de la piste considérée la densité de courant n'est pas trop élevée.

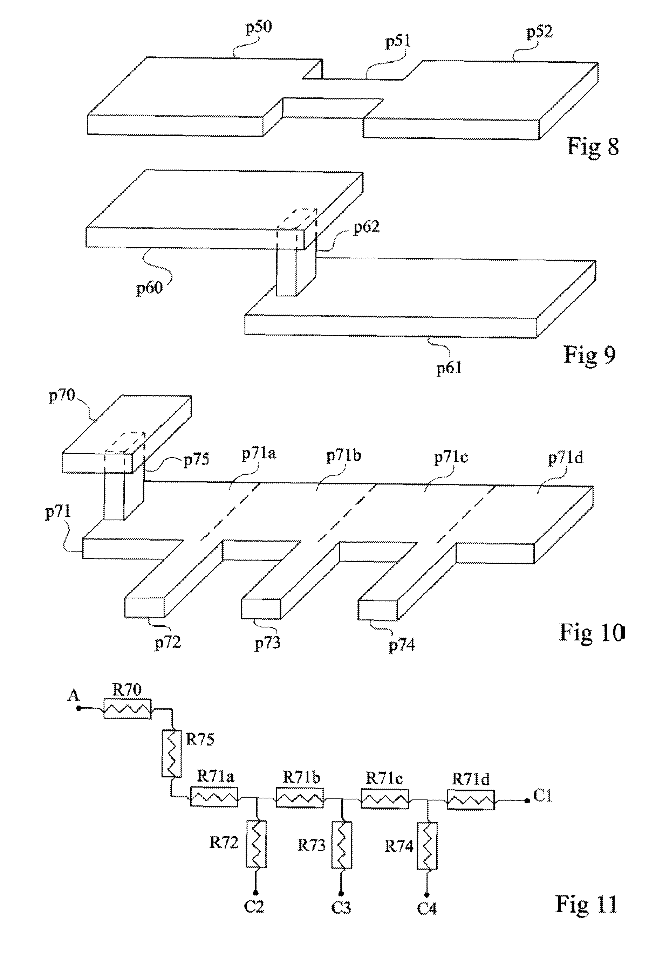

La figure 8 est une vue en perspective d'une piste constituée de trois zones métalliques successives p50, p51 et p52 placées sur un même niveau de métallisation. Les zones ont toutes la même épaisseur, comme cela est courant dans les circuits intégrés. Les zones p50 et p52 sont relativement larges et la zone p51 reliant les deux autres zones est relativement étroite.

La figure 9 est une vue en perspective d'une autre piste constituée de deux zones métalliques relativement larges p60 et p61 placées sur deux niveaux de métal adjacents, la zone p61 étant placée sur le niveau inférieur. Un via conducteur p62 relativement mince relie un bout de la zone p60 à un bout de la zone p61.

Dans les deux exemples susmentionnés, il apparaît clairement que la zone étroite p51 et le via conducteur p62 sont les éléments de piste à travers lesquels la densité de courant risque d'être élevée. Un morceau de piste bien plus étroit que le reste est souvent une erreur de conception que l'on peut rencontrer assez fréquemment dans un circuit hiérarchique lorsqu'il n'est pas toujours aisé de visualiser l'ensemble des zones de la piste appartenant à des niveaux hiérarchiques différents. La présence d'un seul via conducteur relativement étroit entre deux zones métalliques placées sur des niveaux adjacents est aussi une erreur de conception relativement courante.

Une règle de vérification possible des pistes correspondant à des connexions sur lesquelles sont susceptibles de se propager des signaux de type "pic de courant" ou "fort courant" est la suivante. Le rapport des sections de deux zones consécutives d'une piste ne doit pas être supérieur ou inférieur à des valeurs seuil prédéterminées. Les valeurs seuils sont fixées en fonction des paramètres technologiques tels que le type de matériau et sa résistance.

Dans le cas du problème de chute de tension, on cherche à déterminer si les pistes correspondant à des connexions sur lesquelles sont susceptibles de se propager des signaux de type "stable" ne sont pas trop résistives.

La figure 10 est une vue en perspective d'une piste destinée à propager la tension d'alimentation du circuit. La piste comprend une zone métallique p70 placée par exemple sur un deuxième niveau de métallisation et quatre zones métalliques p71, p72, p73 et p74 placées sur un premier niveau de métallisation. La zone p71 a sensiblement la forme d'un rail. Un bout de la zone p70 est relié à un bout de la zone p71 par un via conducteur p75. Les zones p72, p73 et p74, de mêmes longueurs, sont placées à intervalles réguliers contre la zone p71 perpendiculairement à cette dernière, la piste p72 étant la plus proche du via conducteur p75. Le bout de la zone p70 non relié au via p75 est relié à une borne d'alimentation. La tension d'alimentation se propage ensuite par le via conducteur jusqu'au bout des zones p71 à p74.

La figure 11 est un schéma électrique équivalent de la piste représentée en figure 10. Chaque zone ou portion de zone peut être modélisée par une résistance. La zone p70 a une résistance équivalente R70, le via conducteur une résistance équivalente R75. La zone p71 en forme de rail est découpée en quatre zones p71a, p71b, p71c et p71d en partant du via conducteur, les limites entre ces zones étant placées dans le prolongement des zones p72, p73 et p74. Les zones p71a, p71b, p71c et p71d ont respectivement des résistances équivalentes R71a, R71b, R71c et R71d. Les zones p72, p73 et p74 ont des résistances équivalentes R72, R73 et R74. Sur le schéma électrique équivalent de la piste, les résistances R70, R75, R71a, R71b, R71c et R71d sont placées en série entre une borne A par laquelle est alimenté le circuit et une borne C1 reliée à un composant du circuit non représenté. Les résistances R72, R73 et R74 ont chacune une borne connectée respectivement entre R71a/R71b, R71b/R71c et R71c/R71d. Les bornes libres des résistances R72, R73 et R74 sont respectivement nommées C2, C3 et C4 et sont reliées à des composants non représentés. Les zones p72, p73 et p74 étant de mêmes longueurs, les résistances R72, R73 et R74 sont identiques.

En considérant que chacun des composants reliés aux bornes C1 à C4 est susceptible de conduire un courant identique, et sachant que la chute de tension aux bornes d'une résistance est proportionnelle à sa résistance et au courant la traversant, il apparaît clairement qu'une chute de tension d'alimentation maximale pourra être détectée au niveau des bornes C1 et C4.

Une règle de vérification possible des pistes correspondant à des connexions sur lesquelles sont susceptibles de se propager des signaux de type "stable" est la suivante. La résistance équivalente entre "un point de départ" et "un point d'arrivée" de la piste, le long de laquelle se propage le signal, doit être inférieure à une valeur prédéterminée.

Dans le cas du problème de couplages capacitifs parasites, on cherche à déterminer si les pistes susceptibles de propager des signaux de type "horloge" ou "HF" ne sont pas trop près d'autres pistes du circuit, ce qui pourrait induire un changement d'état de ces autres pistes, ou bien une avance ou un retard du signal se propageant sur ces autres pistes.

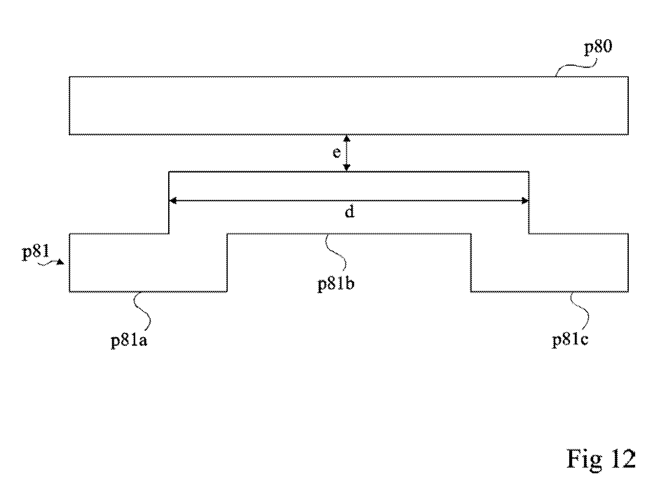

La figure 12 est une vue de dessus de deux pistes p80 et p81 placées sur un même niveau de métallisation. La piste p80 est rectiligne et apparaît horizontale sur la figure 12. La piste p81 est placée à proximité de la piste p80 sensiblement parallèlement à cette dernière. La piste p81 est composée sensiblement de trois portions successives p81a, p81b et p81c rectilignes et apparaissant horizontales. Les deux portions p81a et p81c sont placées à chaque extrémité sur le même axe. La portion p81b, en contact à chaque bout avec les autres portions p81a et p81c, est décalée du côté de la piste p80.

La capacité parasite entre deux pistes étant inversement proportionnelle à l'écartement entre les pistes, la proximité de la piste p80 et de la portion de piste p81b contribue fortement à créer une capacité parasite non négligeable entre les pistes p80 et p81. De plus, la capacité parasite entre deux pistes est proportionnelle à leurs surfaces en regard. Dans cet exemple, la capacité parasite entre les pistes p80 et p81 est sensiblement proportionnelle à la longueur d de la portion de piste p81b.

Une règle de vérification possible des pistes correspondant à des connexions sur lesquelles sont susceptibles de se propager des signaux de type "HF" ou "horloge" est la suivante. Dans un premier temps on recherche si une piste du circuit est "proche" de la piste étudiée, c'est à dire si l'écartement entre la piste étudiée et une autre piste du circuit est inférieur à une distance prédéterminée. Ensuite, dans le cas où tout ou partie d'une piste est proche de la piste étudiée, on évalue la surface en regard entre ces deux pistes afin de déterminer la capacité parasite entre ces pistes. La capacité parasite calculée doit alors être inférieure à une valeur prédéterminée.

En parallèle ou à la suite de l'établissement des règles qui doivent être vérifiées par chacun des types de signaux que l'on souhaite étudier, on détermine quels sont le ou les types de signaux susceptibles de se propager sur les connexions du circuit que l'on souhaite vérifier. On vérifie ensuite que chaque piste correspondant à une connexion que l'on souhaite étudier vérifie les règles correspondant aux types de signaux susceptibles de se propager sur la connexion considérée.

A l'issue de cette vérification, on pourra afficher la représentation physique du circuit et mettre en surbrillance les pistes susceptibles de présenter un défaut technique. Un avantage de la présente invention est que, grâce à la description physique annotée, il est possible d'identifier rapidement et facilement l'ensemble des polygones d'une piste défectueuse. Ainsi, dans le cas où la représentation physique du circuit comprend un grand nombre de niveaux hiérarchiques, il est possible de mettre en surbrillance l'ensemble des polygones d'une piste placés sur des niveaux hiérarchiques différents.

En outre, le procédé de vérification selon la présente invention peut être mis en oeuvre sur une petite partie du circuit sans qu'il soit nécessaire d'effectuer une extraction de l'ensemble des composants parasites du circuit. De plus, il n'est pas nécessaire d'effectuer une simulation électrique de l'ensemble du circuit nécessitant de nombreuses ressources informatiques. Une fois la représentation physique annotée constituée, les diverses portions de circuit peuvent avantageusement être vérifiées en parallèle. Ceci permet d'effectuer une analyse en un temps très court.

Bien entendu, la présente invention est susceptible de diverses variantes et modifications qui apparaîtront à l'homme de l'art. En particulier, on pourra chercher à détecter des problèmes différents de ceux susmentionnés. En outre, on pourra prévoir différentes règles de vérification des pistes correspondant à des connexions sur lesquelles sont susceptibles de se propager des signaux d'un type donné. De plus, l'homme de l'art pourra définir d'autres types de signaux susceptibles de se propager sur une connexion du circuit.

## Revendications

1. Procédé de vérification des connexions d'un circuit intégré comprenant des composants reliés par lesdites connexions, le circuit intégré étant défini par une représentation "physique" et une représentation "schématique", la représentation physique consistant en un assemblage de polygones de divers types utilisés pour réaliser un jeu de masques servant à la fabrication du circuit intégré, la représentation schématique définissant symboliquement les composants du circuit et les connexions entre ces composants, le procédé comprenant les étapes suivantes :
- établir une description physique annotée du circuit qui permette d'associer à chaque connexion de la représentation schématique l'ensemble des polygones de la représentation physique correspondant à la connexion considérée, chaque ensemble de polygones associé à une connexion constituant une piste ;
- analyser les pistes correspondant aux connexions que l'on souhaite vérifier.

2. Procédé selon la revendication 1, dans lequel l'étape d'analyse comprend les étapes suivantes :
- définir au moins un type de signal électrique susceptible de se propager sur les diverses connexions du circuit ;
- définir, pour chaque type de signal, une ou plusieurs règles devant être vérifiées par chacune des pistes correspondant aux connexions sur lesquelles le type de signal considéré est susceptible de se propager, des caractéristiques géométriques propres d'une piste donnée et/ou des caractéristiques relatives au positionnement d'une piste donnée par rapport à d'autres pistes devant être vérifiées pour chaque règle ;
- déterminer, pour chacune des connexions que l'on souhaite vérifier, si les pistes associées à ces connexions vérifient la ou les règles correspondant aux types de signaux susceptibles de se propager sur chacune de ces connexions.

3. Procédé selon la revendication 2, dans lequel au moins un type de signal fait référence à une valeur d'intensité et/ou à une variation temporelle de l'intensité du courant traversant une connexion donnée, et dans lequel une règle devant être vérifiée par chacune des pistes correspondant aux connexions sur lesquelles lesdits au moins un type de signal sont susceptibles de se propager consiste à vérifier que le rapport des sections des zones du circuit intégré correspondant à deux polygones consécutifs d'une piste est compris entre deux valeurs prédéterminées.

4. Procédé selon la revendication 2, dans lequel au moins un type de signal fait référence à une tension sensiblement stable temporellement sur une connexion donnée, et dans lequel une règle devant être vérifiée par chacune des pistes correspondant aux connexions sur lesquelles lesdits au moins un type de signal sont susceptibles de se propager consiste à vérifier que la résistance équivalente des zones du circuit intégré correspondant à tout ou partie de la piste considérée n'est pas supérieure à une valeur prédéterminée.

5. Procédé selon la revendication 2, dans lequel au moins un type de signal fait référence à une variation temporelle rapide du potentiel électrique d'une connexion donnée, et dans lequel une règle devant être vérifiée par chacune des pistes correspondant aux connexions sur lesquelles lesdits au moins un type de signal sont susceptibles de se propager consiste à vérifier si une portion de la piste considérée est située à proximité d'une autre piste avec une distance inférieure à une valeur prédéterminée, et si tel est le cas à vérifier si la capacité parasite entre la piste considérée et ladite autre piste est supérieure à une valeur maximale prédéfinie.

6. Procédé selon la revendication 1, dans lequel les représentations physique et schématique sont construites de façon hiérarchique, les organisations hiérarchiques de chacune des représentations étant éventuellement différentes.
